# EUROPEAN PATENT APPLICATION

(11) **EP 3 825 680 A1**
(43) Date of publication of application: **26.05.2021**
(21) Application number: 18926692.7
(22) Date of filing: 19.07.2018
(51) Int. Cl.: G01N 21/956, H05K 13/08

(54) **TEST SETTING DEVICE AND TEST SETTING METHOD**

(71) Applicant: Fuji Corporation, Chiryu-shi, Aichi 472-8686 (JP)
(72) Inventor: KOBAYASHI, Takahiro, Chiryu-shi, Aichi 472-8686 (JP); AMANO, Masafumi, Chiryu-shi, Aichi 472-8686 (JP); YOKOI, Yuta, Chiryu-shi, Aichi 472-8686 (JP); KITO, Shuichiro, Chiryu-shi, Aichi 472-8686 (JP)
(74) Representative: Grünecker Patent- und Rechtsanwälte PartG mbB
(86) International application number: PCT/JP2018/027089
(87) International publication number: WO 2020/016991

(57) **Abstract**

The test setting device is provided with a determination section and a setting section. When the determination section is executed in a production process in which a board product is produced by a board work machine and the results of image processing for recognizing the state of a constituent site included in the board product fall within a first tolerance range determining the results to be normal, the determination section determines whether the results of the image processing fall within a second tolerance range. The second tolerance range is a tolerance range smaller than the first tolerance range and is set in view of variations in the constituent site and the image processing. When it is determined by the determination section that the results of image processing do not fall within the second tolerance range, the setting section sets the testing criterion for the determined constituent site more strictly than before the determination.

## Description

### Technical Field

The present specification discloses technology related to a test setting device and a test setting method.

### Background Art

A testing device described in Patent Literature 1 includes a work procedure determination section. The work procedure determination section determines a work procedure for testing a circuit board based on board work information, which is work information for circuit board work performed on a circuit board. The work procedure determination section selects a testing target as a mounting target having a high possibility of incurring a mounting failure, the mounting target being, for example, a mounting target having performed with a nozzle having a high mounting failure rate, a mounting target involving a feeder that has been used for a long time, or the like.

### Patent Literature

Patent Literature 1: JP 2003-124699

### Summary of the Invention

### Technical Problem

In a production process for producing a board product, a board work machine for performing predetermined work on a board executes image processing to ensure the reliability of the work. However, there is a possibility for the board work machine to misrecognize foreign matter or variation in brightness in the vicinity of a constituent site of the board product as a constituent site. As a result, there is a possibility that the board work machine will erroneously make a determination of normality in image processing in which a determination of abnormality should be made. In this case, it is necessary to improve the testing accuracy in the testing process of the board product.

In view of the above circumstance, the present specification discloses a test setting device and a test setting method capable of improving the testing accuracy of a board product when there is a possibility that an erroneous determination of normality will be made in image processing in which a determination of abnormality should be made.

### Solution to Problem

The present specification discloses a test setting device including a determination section and a setting section. When the determination section is executed in a production process in which a board product is produced by a board work machine and the results of image processing for recognizing the state of a constituent site included in the board product fall within a first tolerance range determining the results to be normal, the determination section determines whether the results of the image processing fall within a second tolerance range. The second tolerance range is smaller than the first tolerance range and is set in consideration of variations in the constituent site and the image processing. When it is determined by the determination section that the results of the image processing are not included within the second tolerance range, the setting section sets the determined testing criterion for the constituent site more strictly than before the determination.

Further, the present specification discloses a test setting method comprising a determination step and a setting step. When the determination step is executed in a production process in which a board product is produced by a board work machine and the results of image processing for recognizing the state of a constituent site included in the board product fall within a first tolerance range determining the results to be normal, the determination step determines whether the results of the image processing fall within a second tolerance range. The second tolerance range is smaller than the first tolerance range and is set in consideration of variations in the constituent site and the image processing. When it is determined by the determination step that the results of the image processing are not included within the second tolerance range, the setting step sets the determined testing criterion for the constituent site more strictly than before the determination.

### Advantageous Effect of the Invention

With the above-mentioned test setting device, a determination section is provided. With the determination section, the test setting device can extract results (i.e., the recognition results of the constituent site of the board product) of image processing in which there is a possibility that an erroneous determination of normality has been made in image processing in which a determination of abnormality should be made. Further, with the above-mentioned test setting device, a setting section is provided. With the setting section, the test setting device can set the testing criterion for the constituent site more strictly than before the determination, and the testing accuracy can be improved. What has been described above with respect to the test setting device is the same with respect to the test setting method.

### Brief Description of Drawings

[Fig. 1] A configuration diagram showing an example configuration of board work line WML.
[Fig. 2] A plan view showing a configuration of component mounting machine WM3.
[Fig. 3] A schematic diagram showing an example of board product BP.
[Fig. 4] A schematic diagram showing an example of results of image processing.
[Fig. 5] A block diagram showing an example of a control block of control device 16.
[Fig. 6] A schematic diagram showing another example of board product BP.

### Description of Embodiments

### 1. Embodiment

### 1-1. Example configuration of board work line WML for boards

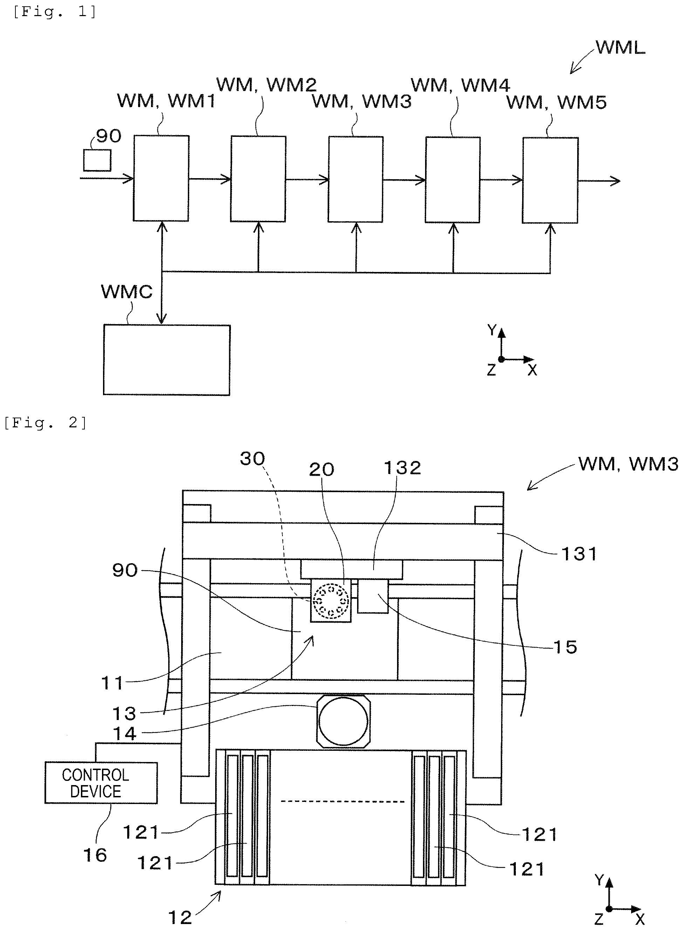

In board work line WML, predetermined work is performed on board 90. The type and number of board work machines WM constituting board work line WML are not limited. As shown in Fig. 1, board work line WML of the present embodiment has multiple (five) board work machines WM, including printing machine WM1, print testing machine WM2, component mounting machine WM3, reflow furnace WM4, and visual testing machine WM5. The multiple (five) board work machines WM are arranged starting from upstream in the order of printing machine WM1, print testing machine WM2, component mounting machine WM3, reflow furnace WM4, and visual testing machine WM5. Board 90 is conveyed into printing machine WM1 located at the leading end of board work line WML. Board 90 is then conveyed downstream by board conveyance device (not shown) of board work line WML and is conveyed out of visual testing machine WM5 located at the end of board work line WML.

Printing machine WM1 prints solder at mounting positions on board 90 for each of the multiple components (for convenience of explanation, three components P1 to P3). The solder printed on board 90 is paste-like and has a predetermined viscosity. The solder functions as a bonding material for joining board 90 and the multiple (three) components P1 to P3 mounted on board 90. Print testing machine WM2 tests the printing status of the solder printed by printing machine WM1. Component mounting machine WM3 mounts multiple (three) components P1 to P3 on solder printed by printer WM1. There may be one or more component mounting machines WM3. When multiple component mounting machines WM3 are provided, mounting of the multiple (three) components P1 to P3 can be divided among the multiple component mounting machines WM3.

Reflow furnace WM4 heats board 90 on which the multiple (three) components P1 to P3 have been mounted by component mounting machine WM3, melts the solder, and performs soldering. Visual testing machine WM5 tests the mounting status of the multiple (three) components P1 to P3 mounted by component mounting machine WM3. Specifically, visual testing machine WM5 recognizes the appropriateness of the multiple (three) components P1 to P3 mounted on board 90 and the mounting conditions of the multiple (three) components P1 to P3 on board 90 as indicated by the mounting positions, the mounting angles, and the like of each of the multiple (three) components P1 to P3, and transmits the information to control device WMC. Thus, using the multiple (five) board work machines WM, it is possible for board work line WML to sequentially convey board 90 and execute a production process including the testing process to produce board product BP.

Board work line WML can, for example, be provided with a function testing machine which is a board work machine WM. The function testing machine performs a function test of board 90 soldered by reflow furnace WM4. In addition, the configuration of board work line WML can, for example, be appropriately added to board work line WML in accordance with the type of board product BP to be produced, and the configuration can be changed as appropriate. Board work line WML may include board work machines WM such as, for example, a buffer device, a board supplying device, a board flipping device, a shield mounting device, an adhesive application device, and an ultraviolet ray irradiation device.

The multiple (five) board work machines WM and management device WMC constituting board work line WML are connected in communication with each other. Management device WMC controls the multiple (five) board work machines WM constituting board work line WML and monitors the operational state of board work line WML. Management device WMC stores various data for controlling the multiple (five) board work machines WM. Management device WMC transmits the data to the multiple (five) board work machines WM. In addition, the multiple (five) board work machines WM constituting board work line WML transmit the operational state and the production state to management device WMC.

### 1-2. Example configuration of component mounting machine WM3

Component mounting machine WM3 produces board product BP by mounting multiple (three) components P1 to P3 on board 90. As shown in Fig. 2, component mounting machine WM3 includes board conveyance device 11, component supply device 12, component transfer device 13, part camera 14, board camera 15, and control device 16. Board conveyance device 11 is constituted by, for example, a belt conveyor or the like and conveys board 90 in the conveyance direction (i.e., the X-axis direction). Board 90 is a circuit board on which electronic or electrical circuits are formed. Board conveyance device 11 position board 90 at a predetermined position in the machine in addition to conveying board 90 into component mounting machine WM3. After the mounting of the multiple (three) components P1 to P3 by component mounting machine WM3 is completed, board conveyance device 11 conveys board 90 out of component mounting machine WM3.

Component supply device 12 supplies the multiple (three) components P1 to P3 to be mounted on board 90. Component supply device 12 includes multiple feeders 121 provided along the conveyance direction of board 90 (i.e., the X-axis direction). Each of the multiple feeders 121 pitch feeds a carrier tape in which multiple components are accommodated to supply components at a supply position located at the distal end of feeder 121 in a manner which allows the components to be picked up. Component supply device 12 can also supply electronic components (e.g., lead components, etc.) that are relatively large compared to chip components in an arranged manner on a tray.

Component transfer device 13 includes head driving device 131 and moving table 132. Head driving device 131 is configured with moving table 132 capable of moving in the X-axis direction and the Y-axis direction by way of a linear motion mechanism. Component mounting head 20 is detachably provided to moving table 132 by way of a clamping member (not shown). Component mounting head 20 picks up and holds multiple (three) components P1 to P3 supplied by component supply device 12 using at least one holding member 30 and mounts multiple (three) of components P1 to P3 on board 90 positioned by board conveyance device 11. A suction nozzle, a chuck, or the like can be used as holding member 30.

Part camera 14 and board camera 15 can use, for example, a digital imaging device having an image pickup device. For an image pickup device, an image sensor such as a charge-coupled device (CCD) or an image sensor or a complementary metal-oxide-semiconductor (CMOS) can be used. Part camera 14 and board camera 15 perform imaging based on control signals sent from control device 16. Image data of images captured by part camera 14 and board camera 15 is transmitted to control device 16.

Part camera 14 is fixed to the base of component mounting machine WM3 so that the optical axis is upward in the Z-axis direction (vertical upward direction). Part camera 14 can image multiple (three) components P1 to P3 held by at least one (e.g., three) holding member 30 from below. Board camera 15 is provided on moving table 132 of component transfer device 13 so that the optical axis is downward in the Z-axis direction (vertical downward direction). Board camera 15 can image board 90 from above.

Control device 16 includes a known central processing unit and storage device, and includes a control circuit (both of which are not shown). Central processing unit is a CPU and can perform various arithmetic processes. The storage device includes a first storage device and a second storage device. The first storage device is a volatile storage device (RAM: Random Access Memory) and the second storage device is a nonvolatile storage device (ROM: Read Only Memory). Control device 16 receives as input, information outputted from various sensors provided on component mounting machine WM3, image data and the like. Control device 16 sends a control signal to component transfer device 13 based on a control program, a predetermined mounting condition set in advance, and the like.

Specifically, control device 16 causes multiple (three) holding members 30 to pick up and hold multiple (three) components P1 to P3 supplied by component supply device 12 and causes part camera 14 to image the multiple (three) holding members 30 holding the multiple (three) components P1 to P3. Control device 16 processes images captured by part camera 14 to recognize the holding orientations of the multiple (three) components P1 to P3. For example, control device 16 can recognize the holding orientations of the multiple (three) components P1 to P3 by determining through image processing a portion serving as a reference position for positioning, a distinctive feature in the appearance of each of the multiple (three) components P1 to P3, and the like.

Control device 16 causes holding member 30 to move toward an upper planned mounting position to be set in advance by a control program or the like. Further, control device 16 corrects the planned mounting position based on, for example, the holding orientation of component P1 and sets the mounting position where component P1 will actually mounted. The planned mounting position and the mounting position include the rotation angle in addition to the position (X-axis coordinate and Y-axis coordinate). Control device 16 corrects the target position and rotation angle of holding member 30 (X-axis coordinate and Y-axis coordinate) in accordance with the mounting position. Control device 16 lowers holding member 30 for which the position (X-axis coordinate and Y-axis coordinate) and the rotation angle have been corrected, and mounts component P1 onto board 90. Control device 16 repeats the pick-and-place cycle described above to execute the mounting of the multiple (three) components P1 to P3 on board 90.

### 1-3. Example of image processing results

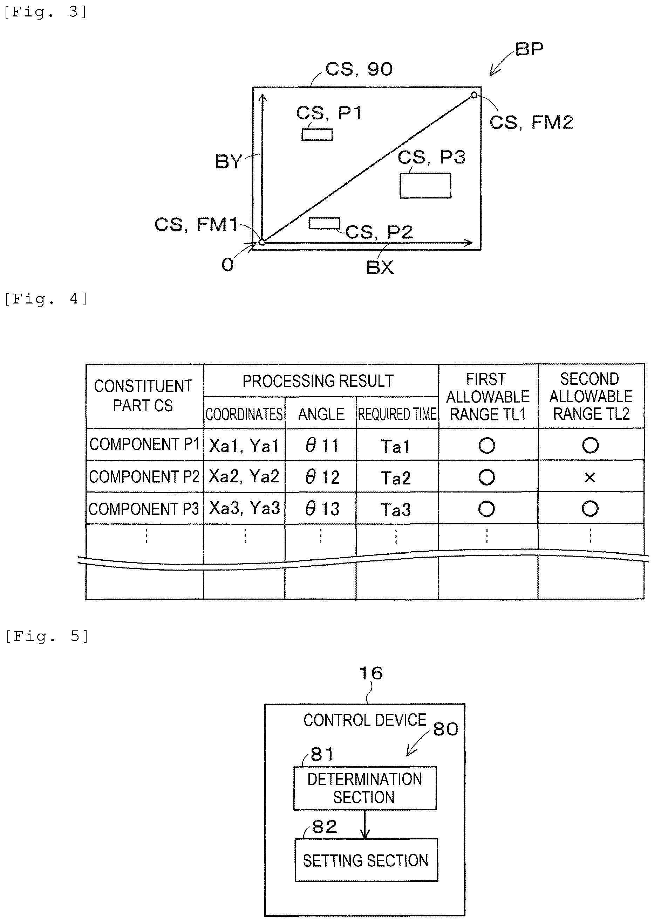

As shown in Fig. 3, multiple (two) mark portions FM1, FM2 are provided on board 90. The multiple (two) mark portions FM1, FM2 are positioning references of board 90 called fiducial marks and are provided on the outer edge of board 90. A board coordinate system is set based on the multiple (two) marks FM1, FM2. The board coordinate system is a coordinate system to be set in board 90, and the board coordinate system can be defined by the multiple (two) mark portions FM1, FM2, X-axis direction BX and Y-axis direction BY, as well as the positional relationship with origin 0.

In the present embodiment, mark portion FM1 is provided at origin 0. Control device 16 can obtain the board coordinate system (X-axis direction BX, Y-axis direction BY, the origin 0) based on, for example, the angle formed by a line segment connecting multiple (two) mark portions FM1, FM2 and X-axis direction BX. Further, the mounting positions of each of the multiple (three) components P1 to P3 on board 90 can be indicated using the board coordinate system.

Control device 16 images, for example, the multiple (two) mark portions FM1, FM2 with board camera 15 and, by image processing the acquired image data, obtains the position and angle of board 90 during the convey-in process of board 90. Control device 16 controls the operation of component transfer device 13 based on the position and angle of acquired board 90 and mounts the multiple (three) components P1 to P3 onto board 90. Further, control device 16 may image the multiple (three) components P1 to P3 mounted on board 90 with board camera 15 and, by image processing the acquired image data, acquire the coordinates and angles of the multiple (three) components P1 to P3.

It should be noted that control device 16 can also perform an pitch-to-pitch test to check whether the spacing between the multiple (two) mark portions FM1, FM2 falls within a prescribed range. For example, when a through hole of board 90 is erroneously recognized as at least one of the multiple (two) mark portions FM1, FM2, the spacing between the multiple (two) mark portions FM1, FM2 will not fall within the prescribed range. Therefore, control device 16 can obtain an erroneous recognition of the multiple (two) mark portions FM1, FM2.

Fig. 4 shows an example of results of image processing. For example, in component P1, results of image processing are indicated by coordinates and an angle. A coordinate of X-axis direction BX is coordinate value Xa1, and a coordinate of Y-axis direction BY is coordinate Ya1. Further, the angle with reference to X-axis direction BX of component P1 is θ11. Further, the time required for image processing the image data of component P1 is required time Ta1. What is described above for component P1 can be said similarly for component P2 and component P3. The results of the pitch-to-pitch test described above can be included in the results of the image processing.

There is a possibility that, in the image data, board work machine WM (in this case, component mounting machine WM3) will, for example, misrecognize foreign matter or variation in brightness in the vicinity of constituent site CS included in board product BP as constituent site CS. As a result, there is a possibility that board work machine WM (component mounting machine WM3) will erroneously make a determination of normality in image processing in which a determination of abnormality should be made. In this case, it is necessary to improve the testing accuracy of the testing step of board product BP. Therefore, board work machine WM of the present embodiment (component mounting machine WM3) is provided with test setting device 80.

### 1-4. Test setting device 80

As shown in Fig. 5, when test setting device 80 is taken as a control block, test setting device 80 is provided with determination section 81 and setting section 82.

### 1-4-1. Determination section 81

When determination section 81 is executed in a production process in which board product BP is produced by board work machine WM and the results of image processing fall for recognizing the state of constituent site CS included in board product BP fall within first tolerance range TL1 determining the results to be normal, determination section 81 determines whether the results of the image processing fall within second tolerance range TL2. Second tolerance range TL2 is a tolerance range smaller than first tolerance range TL1 and is set in view of variations in constituent site CS and the image processing.

In the example shown in Figs. 3 and 4, constituent site CS of board product BP includes board 90, multiple (two) mark portions FM1, FM2 that are positioning references of board 90, and multiple (three) components P1 to P3 mounted on board 90. As shown in Fig. 4, the results of image processing include the results of processing that recognizes coordinates and angles indicating the respective positions of the multiple (three) components P1 to P3 on board 90. The results of the image processing include the time required for image processing. Furthermore, as described above for the pitch-to-pitch test, the results of the image processing may include a process of recognizing the positional relation of the multiple (two) mark portions FM1, FM2 in board 90.

First tolerance range TL1 shown in the drawing is all marked with circles. The circles indicate that the results of the image processing (i.e., the coordinates, angles, and required times in this instance) fall within a tolerance range (first tolerance range TL1) that is determined to be normal. Second tolerance range TL2 shown in the figure is marked with circles for component P1 and component P3 and a cross for component P2. The circles indicate that the results of the image processing (coordinates, angles, and required times) fall within second allowance range TL2. The cross mark indicates that the results of the image processing (coordinates, angles, and required times) do not fall within second allowance range TL2.

The image processing results (coordinates, angles, and required times) of the multiple (three) components P1 to P3, which constitute constituent site CS, fall within first tolerance range TL1 determined to be normal. The image processing results (coordinates, angles, and required times) of the images of components P1 and component P3 all fall within second tolerance range TL2. However, the results of image processing on component P2, that is, the coordinates, angles, and required times do not fall within second tolerance range TL2. Therefore, there is a possibility that the results (coordinates, angles, and required times) of image processing on component P2 were erroneously determined to be normal in image processing in which a determination of abnormality should be made (hereinafter, referred to as "possibility of erroneous determination").

Second tolerance range TL2 is a tolerance range smaller than first tolerance range TL1 and is set in view of variations in constituent site CS and the image processing. The variations of constituent site CS includes, for example, individual differences in constituent sites CS. Individual differences in constituent sites CS may be caused by, for example, differences between manufacturers, differences between production lots, and the like. Further, variations of image processing include, for example, imaging conditions when imaging constituent site CS (e.g., the irradiation direction of light, the amount of light, etc.), differences in the image processing method, and the like. Note that "image processing" may be any type of processing as long as it outputs the state of constituent site CS included in board product BP as a result. "Image processing" may be a type of processing such as binarization or edge processing, or may consist of multiple processes combining these processing types.

Second tolerance range TL2 is preferably set in consideration of at least one of values designated by an operator who operates board work machine WM and statistical values of results of image processing performed multiple times prior to the current image processing. The values designated by the operator can be individually designated, for example, for each of the multiple constituent sites CS to be targeted. The values designated by the operator can also be designated collectively for multiple target constituent sites CS by, for example, taking a ratio (e.g., 50%) of first tolerance range TL1.

The statistical values of results of image processing can be set based on, for example, an average value, a median value, or a mode value of the results of image processing. For example, when image processing is performed to an extent at which the statistical values become significant, second tolerance range TL2 can be set to a contemplated range based on the results of the image processing. Determination section 81 can also set second tolerance TL2 by switching between the designated values designated by the operator and the statistical values of the results of image processing. In this case, for example, determination section 81 may set the designated values designated by the operator as the initial values of second tolerance range TL2, and switch second tolerance range TL2 from the designated values to the statistical values when the number of executions of image processing exceeds a predetermined number of times.

It is preferable for determination section 81 to determine whether the time required for image processing falls within second tolerance range TL2. For example, in the case where, in the image data, foreign matter or variation in brightness in the vicinity of constituent site CS is erroneously recognized as constituent site CS, the time required for image processing is likely to be long. Therefore, determination section 81 can use the time required for image processing as a determination criterion. Further, as shown in Fig. 3, constituent site CS includes board 90 and multiple (three) components P1 to P3 mounted on board 90. In this instance, it is preferable for determination section 81 to determine whether the results of the process of recognizing at least one of the coordinates and angles indicating the position of each of the multiple (three) components P1 to P3 on board 90 falls within second tolerance range TL2. Thus, determination section 81 can extract the possibility of erroneous determination of image processing for each of the multiple (three) components P1 to P3.

Further, as shown in the drawing, constituent site CS includes board 90 and multiple (two) mark portions FM1, FM2 which are positioning references for board 90. In this instance, it is preferable for determination section 81 to determine whether the results of the process of recognizing the positional relationship of the multiple (two) mark portions FM1, FM2 on board 90 fall within second tolerance range TL2. As a result, determination section 81 can extract the possibility of erroneous determination of image processing with respect to the multiple (two) mark portions FM1, FM2.

Further, as shown in the drawing, constituent site CS includes board 90, multiple (two) mark portions FM1, FM2 which are positioning references of board 90, and multiple (three) components P1 to P3 which are mounted on board 90. In this instance, when determining that the results of image processing do not fall within second tolerance range TL2 for the multiple (two) mark portions FM1, FM2, determination section 81 preferably determines that the results of the image processing do not fall within second tolerance range TL2 for the multiple (three) components P1 to P3.

As described above, the board coordinate system is set based on the multiple (two) mark portions FM1, FM2. Further, the mounting positions of each of the multiple (three) components P1 to P3 on board 90 is indicated using the board coordinate system. Therefore, when the results of image processing of the multiple (two) mark portions FM1, FM2 do not fall within second tolerance range TL2, there is a strong possibility that the results of the image processing on the multiple (three) components P1 to P3 will not fall within second tolerance range TL2. Therefore, when it is determined that the results of image processing do not fall within second tolerance range TL2 for the multiple (two) mark portions FM1, FM2, determination section 81 may determine that the results of the image processing do not fall within second tolerance range TL2 for the multiple (three) components P1 to P3. As a result, determination section 81 simplifies the determination process.

### 1-4-2. Setting section 82

When it is determined by determination section 81 that the results of image processing do not fall within second tolerance range TL2, setting section 82 sets the testing criterion for the determined constituent site CS more strictly than before the determination. In the case shown in Fig. 4, the results of image processing on component P2 (coordinates, angles, and required times) do not fall within second tolerance range TL2. Therefore, setting section 82 strictly sets the testing criterion for component P2 which is constituent part CS. It is preferable for setting section 82 to set at least one of a test target setting, a test item setting, and a test method setting. In the test target setting, when constituent site CS is not a test target, constituent site CS is set as a test target. As a result, setting section 82 can reliably test constituent sites CS that are likely to be erroneously determined in image processing.

In the test item setting, a test item related to constituent site CS is added. Preferably, the test item is at least one of a presence/absence test, a deviation test, and a direction test. In the presence/absence test, the presence/absence of constituent site CS is tested. The deviation test examines the deviation of constituent site CS with respect to a predetermined position where constituent site CS should be located in board product BP. The direction test tests the direction of constituent site CS in board product BP. For example, components of BGAs (Ball Grid Arrays) are provided with an electrode shape in which solder balls are arranged in a grid. Therefore, the mounting direction (polarity) of the component is often defined. The direction test tests the direction (mounting direction (polarity)) of constituent site CS. In this manner, setting section 82 can add test items for testing constituent sites CS having a strong possibility of an erroneous determination in image processing, thereby improving the testing accuracy.

In the test method setting, the test method for constituent site CS is changed to a test method capable of testing with higher accuracy than before the determination by determination section 81. In a high-precision test method, for example, constituent site CS is imaged multiple times while changing the lighting (e.g., irradiation direction, light amount, etc.) at the time of testing, and test results can be obtained from the multiple imaging results. Therefore, in the high-precision test method, the testing time increases, but detailed testing can be performed. As a result, setting section 82 improves the testing accuracy of constituent site CS having a strong possibility of erroneous determination in image processing.

As described above, when determining that the results of image processing do not fall within second tolerance range TL2 for the multiple (two) mark portions FM1, FM2, determination section 81 preferably determines that the results of the image processing do not fall within second tolerance range TL2 for the multiple (three) components P1 to P3. At this juncture, it is preferable for setting section 82 to set at least the test item setting. It is preferable for the test item setting in this case to add test items including at least a deviation test for testing the deviation of the multiple (three) components P1 to P3 with respect to predetermined positions where the multiple (three) components P1 to P3 should be positioned in board product BP. If the results of the image processing for the multiple (two) mark portions FM1, FM2 does not fall within second tolerance range TL2, it is likely that the mounting positions of the multiple (three) components P1 to P3 deviate from the predetermined positions where components P1 to P3 should be positioned. Therefore, it is preferable for setting section 82 to add test items including at least the deviation test.

### 2. Modification

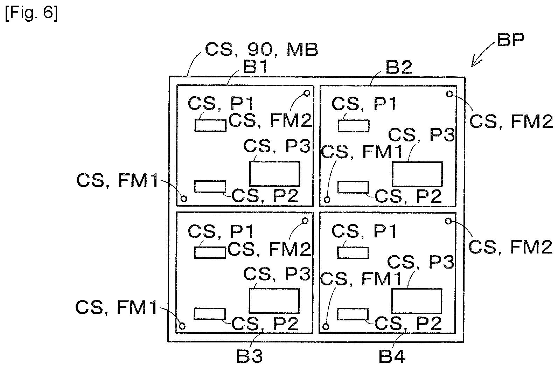

Fig. 6 shows another example of board product BP. Board 90 shown in the drawing is split board MB in which multiple (four) board units B1 to B4 are coupled in a separable manner, and multiple (two) mark portions FM1, FM2 are provided in each of the multiple (four) board units B1 to B4. Further, similar to board product BP shown in Fig. 3, each of the multiple (four) board units B1 to B4, multiple (three) components P1 to P3 are mounted.

Determination section 81 determines that the results of image processing do not fall within second tolerance range TL2 for the multiple (two) mark portions FM1, FM2 of a board unit (for example, board unit B2) that is a portion of the multiple (four) board units B1 to B4. At this juncture, it is preferable for determination section 81 to determine that the results of image processing do not fall within second tolerance range TL2 for the multiple (three) components P1 to P3 mounted on board unit B2. As a result, determination section 81 simplifies the determination process. Also in this modification, it is preferable that setting section 82 sets at least the test item setting. In this case, it is preferable to perform the test item setting for the multiple (three) components P1 to P3 mounted on board unit B2.

### 3. Arrangement of determination section 81 and setting section 82

The arrangement of determination section 81 and setting section 82 is preferably a first arrangement or a second arrangement. The first arrangement refers to an arrangement in which both determination section 81 and setting section 82 are provided in board work machine WM or management device WMC that manages board work machine WM. As shown in Fig. 5, the present embodiment is a first arrangement, with both determination section 81 and setting section 82 being provided in a board work machine WM (i.e., component mounting machine WM3). The second arrangement refers to an arrangement in which one of determination section 81 and setting section 82 is provided in board work machine WM and the other is provided in management device WMC. In either the first arrangement or the second arrangement, it is preferable for setting section 82 to instruct visual testing machine WM5, which tests board products BP, regarding the testing criterion for constituent site CS. When at least one of determination section 81 and setting section 82 is provided in management device WMC, necessary data such as results of image processing is transmitted from board work machine WM to management device WMC.

Further, determination section 81 may be provided in management device WMC for managing board work machine WM or a board work machine WM other than visual testing machine WM5 for testing board product BP, and setting section 82 may be provided in visual testing machine WM5. In this case, it is preferable for visual testing machine WM5 to query board work machine WM or management device WMC provided with determination section 81 about the determination results of image processing prior to testing board product BP.

### 4. Other

Using board camera 15, component mounting machine WM3 described above images constituent site CS of board product BP and obtains the results of image processing by image processing the acquired image data. Component mounting machine WM3 can also image constituent site CS using, for example, part camera 14 to obtain the results of image processing. In this case, it is preferable for constituent site CS to include, for example, the multiple (three) components P1 to P3 held by holding member 30.

In addition, component mounting machine WM3 can obtain results of image processing by capturing images of the same constituent site CS with different imaging devices multiple times. In this case, component mounting machine WM3 can, for example, use an imaging device capable of imaging the component held by holding member 30 from the side and part camera 14 capable of imaging the component from below to capture images of the component and obtain results of image processing. Further, determination section 81 can set second tolerance range TL2 based on the results of these images.

Test setting device 80 may also be provided in other board work machines WM other than component mounting machine WM3. For example, test setting device 80 may be provided in print machine WM1. In this case, constituent site CS of board product BP may include, for example, solder printed on board 90.

### 5. Test setting method

The above description of test setting device 80 can be similarly applied to the test setting method. Specifically, the test setting method includes a determination step and a setting step. When the determination step is executed in a production process in which board product BP is produced by board work machine WM and the results of image processing for recognizing the state of constituent site CS included in board product BP fall within first tolerance range TL1 determining the results to be normal, the determination step determines whether the results of the image processing fall within second tolerance range TL2. Second tolerance range TL2 is a tolerance range smaller than first tolerance range TL1 and is set in view of variations in constituent site CS and the image processing. When it is determined by the determination step that the results of the image processing are not included within second tolerance range TL2, the setting step sets the determined testing criterion for constituent site CS more strictly than before the determination. That is, the determination step corresponds to the controlling done by determination section 81. The setting step corresponds to the controlling done by setting section 82.

### 6. Example of the effect of the embodiment

Test setting device 80 includes determination section 81. With determination section 81, test setting device 80 can extract results (i.e., the recognition results of constituent site CS of board product BP) of image processing in which there is a possibility that an erroneous determination of normality has been made in image processing in which a determination of abnormality should be made. Test setting device 80 includes setting section 82. With setting section 82, test setting device 80 can set the testing criterion for constituent site CS more strictly than before the determination, and the testing accuracy can be improved. What has been described above with respect to test setting device 80 is the same with respect to the test setting method.

### Reference Signs List

80: Test setting device, 81: Determination section, 82: Setting section, 90: Board, WM: Board work machine, WM5: Visual testing machine, WMC: Control device, BP: Board product, CS: Constituent site, TL1: First tolerance range, TL2: Second tolerance range, P1 to P3: Component, FM1, FM2: Mark portion, MB: Split board, B1 to B4: Board unit

## Claims

1. A test setting device comprising:
a determination section configured to determine whether results of image processing fall within a second tolerance range, when an image processing is executed in a production process in which a board product is produced by a board work machine and the results of the image processing for recognizing the state of a constituent site included in a board product fall within a first tolerance range determining the results to be normal, the second tolerance range being smaller than the first tolerance range and set in consideration of variations in the constituent site and the image processing, and
a setting section configured to set testing criterion for the determined constituent site more strictly than before the determination that the results of the image processing do not fall within the second tolerance range is made by the determination section, when the determination is made.

2. The test setting device of claim 1, wherein
the setting section sets at least one of: a test target setting for setting the constituent site as a test target when the constituent site is not a test target; a test item setting for adding a test item related to the constituent site; and a test method setting for changing the test method for the constituent site to a test method capable of testing with higher accuracy than before the determination being made.

3. The test setting device of claim 2, wherein the test item is at least one of a presence/absence test for testing the presence/absence of the constituent site, a deviation test for testing the deviation of the constituent site with respect to a predetermined position where the constituent site should be located in the board product, and a direction test for testing the direction of the constituent site in the board product.

4. The test setting device of any one of claims 1 to 3, wherein the second tolerance range is set in consideration of at least one of values designated by an operator who operates board work machine and statistical values of results of image processing performed multiple times prior to the current image processing.

5. The test setting device of any one of claims 1 to 4, wherein the results of the image processing include the time required for image processing, and the determination section determines whether the time required for image processing falls within the second tolerance range.

6. The test setting device of any one of claims 1 to 5,
wherein the constituent site includes a board and multiple components mounted on the board, and
wherein the image processing is a process for recognizing at least one of either the coordinates or the angle indicating the position of each of the multiple components on the board.

7. The test setting device of any one of claims 1 to 6, wherein the constituent site includes a board and multiple mark portions serving as positioning references for the board, and the image processing is a process for recognizing the positional relationship of the multiple mark portions on the board.

8. The test setting device of any one of claims 1 to 7, wherein the constituent site includes a board, multiple mark portions serving as positioning references for the board, and multiple components to be mounted on the board; and the determination section determines that the results of the image processing do not fall within the second tolerance range for the multiple components when it is determined that the results of the image processing do not fall within the second tolerance range for the multiple mark portions.

9. The test setting device of claim 8,
wherein the board is a split board in which multiple board units are coupled in a separable manner,
wherein multiple mark portions are provided in each of the multiple board units; and
wherein the determination section determines that the results of image processing do not fall within the second tolerance range for the multiple components mounted on a board unit that is a portion of the multiple board units, when it is determined that the results of image processing do not fall within the second tolerance range for the multiple mark portions of the board unit.

10. The test setting section of claim 8 or claim 9, which are dependent on claim 3, wherein the setting section sets at least the test item setting which adds test items including at least a deviation test for testing the deviation of the multiple components with respect to predetermined positions where the multiple components should be positioned in the board product.

11. The test setting device of any one of claims 1 to 10, wherein
the arrangement of the determination section and the setting section is a first arrangement in which both the determination section and the setting section are provided in the board work machine or the management device that manages the board work machine, or a second arrangement in which one of the determination section and the setting section is provided in the board work machine and the other is provided in the management device; and
the setting section instructs the visual testing machine, which tests board products, regarding the testing criterion for the constituent site.

12. The test setting device of any one of claims 1 to 10,
wherein the determination section is provided in a board work machine other than the visual testing machine for testing the board product or a management device for managing the board work machine,
wherein the setting section is provided in the visual testing machine; and
wherein the visual testing machine queries the board work machine or the management device provided with the determination section about the results of image processing prior to testing the board product.

13. A test setting method comprising:
a determination step for determining whether results of image processing fall within a second tolerance range, when the determination section is executed in a production process in which a board product is produced by a board work machine and the results of image processing for recognizing the state of a constituent site included in a board product fall within a first tolerance range determining the results to be normal, the second tolerance range being smaller than the first tolerance range and set in consideration of variations in the constituent site and the image processing, and
a setting step for setting testing criterion for the determined constituent site more strictly than before the determination when it is determined by the determination section that the results of the image processing do not fall within the second tolerance range.
